# FASCICULE DE BREVET EUROPEEN

(11) **EP 4 117 045 B1**
(45) Date de publication et mention de la délivrance du brevet: **18.10.2023**
(21) Numéro de dépôt: 22180818.1
(22) Date de dépôt: 23.06.2022
(51) Int. Cl.: H01L 31/0745, H01L 31/078

(54) **PROCEDE DE REALISATION D'UNE CELLULE PHOTOVOLTAÏQUE TANDEM**
VERFAHREN ZUR HERSTELLUNG EINER TANDEM-FOTOVOLTAIKZELLE
METHOD FOR PRODUCING A TANDEM PHOTOVOLTAIC CELL

(30) Priorité: 28.06.2021 FR 2106914
(43) Date de publication de la demande: 11.01.2023
(73) Titulaire: Commissariat à l'énergie atomique et aux énergies alternatives, 75015 Paris (FR)
(72) Inventeur: MARTEL, Benoît, 38054 GRENOBLE CEDEX 09 (FR); DESRUES, Thibaut, 38054 GRENOBLE CEDEX 09 (FR)
(74) Mandataire: Brevalex

(56) Documents cités:
- EP-A1- 3 671 864
- WO-A1-2020/204823
- PEIBST ROBBY ET AL: "From PERC to Tandem: POLO- and p+/n+ Poly-Si Tunneling Junction as Interface Between Bottom and Top Cell", IEEE JOURNAL OF PHOTOVOLTAICS, IEEE, vol. 9, no. 1, 1 janvier 2019 (2019-01-01) , pages 49-54, XP011694435, ISSN: 2156-3381, DOI: 10.1109/JPHOTOV.2018.2876999 [extrait le 2018-12-21]

## Description

### DOMAINE TECHNIQUE

L'invention concerne le domaine de la réalisation de cellules photovoltaïques tandem sur semi-conducteur. L'invention s'applique notamment à la réalisation de cellules photovoltaïques tandem sur silicium, et avantageusement à structure pérovskite sur silicium (PK/Si).

### ÉTAT DE LA TECHNIQUE ANTÉRIEURE

Une cellule photovoltaïque tandem comporte deux sous-cellules empilées l'une sur l'autre. Dans une telle cellule, l'une des deux sous-cellules est appelée cellule supérieure (« top cell » en anglais), et l'autre sous-cellule est appelée cellule inférieure (« bottom cell » en anglais).

Une cellule photovoltaïque tandem particulièrement performante (potentiels de rendement élevés, supérieurs à 30%) appelée cellule tandem de structure pérovskite sur silicium, ou PK/Si, comporte une cellule supérieure à base de matériau de structure pérovskite et une cellule inférieure à base de silicium cristallin (monocristallin ou polycristallin). La combinaison de ces deux sous-cellules permet, par rapport à une cellule photovoltaïque comprenant uniquement du silicium, de capter une gamme de longueurs d'onde du spectre solaire plus large, ce qui permet d'obtenir un gain de rendement conséquent.

Il existe plusieurs configurations de cellule tandem :
- configuration à quatre terminaux, dans laquelle chaque sous-cellule est dotée de deux électrodes qui lui sont propres ;
- configuration à trois terminaux, dans laquelle une électrode est commune aux deux sous-cellules et forme à la fois l'électrode inférieure de la cellule supérieure et l'électrode supérieure de la cellule inférieure ;
- configuration à deux terminaux, dans laquelle les deux sous-cellules sont liées l'une à l'autre à l'interface entre les deux sous-cellules.

Dans le cas d'une cellule tandem à deux terminaux, il existe trois possibilités pour réaliser l'interface entre les deux sous-cellules :
- réaliser une jonction tunnel à base de silicium ;
- réaliser une jonction tunnel à base d'oxyde transparent conducteur ;
- ne pas réaliser de jonction tunnel et disposer directement les deux sous-cellules l'une contre l'autre.

Une première possibilité pour réaliser une jonction tunnel à base de silicium consiste à réaliser un empilement de deux couches de silicium amorphe, l'une des deux couches étant dopée n+ et l'autre étant dopée p+, entre lesquelles est insérée une couche de silicium amorphe intrinsèque (non intentionnellement dopé) permettant de limiter la rétrodiffusion des dopants d'une couche à l'autre.

Une deuxième possibilité pour réaliser cette jonction tunnel consiste à réaliser successivement une première couche de silicium polycristallin dopé p+, une première couche de SiOx ou une couche de silicium polycristallin intrinsèque, une deuxième couche de silicium polycristallin dopé n+ et une deuxième couche de SiOx. L'épaisseur totale de ces quatre couches est par exemple de 500 µm. La première couche de silicium polycristallin est dopée p+ par exemple par diffusion de bore, et la deuxième couche de silicium polycristallin est dopée n+ par exemple par diffusion phosphore. Il est également possible de réaliser des dopages in-situ lors des dépôts de ces couches.

Dans tous les cas, la réalisation de la jonction tunnel implique de réaliser au moins deux couches distinctes avec une couche barrière entre elles.

WO 2020/204823 A1 divulgue un procédé de réalisation d'une cellule photovoltaïque tandem.

### EXPOSÉ DE L'INVENTION

Un but de la présente invention est de proposer un procédé de réalisation de cellule photovoltaïque tandem à deux terminaux ne nécessitant pas, pour la réalisation de la jonction tunnel, des dépôts de deux couches dopées distinctes entre lesquelles une couche barrière est insérée.

Pour cela, la présente invention propose un procédé de réalisation d'au moins une cellule photovoltaïque tandem, dans lequel une première sous-cellule de la cellule photovoltaïque tandem est réalisée en mettant en oeuvre les étapes de :
- réalisation d'une première couche d'oxyde sur au moins une première face d'un substrat semi-conducteur ;
- réalisation, sur la première couche d'oxyde, d'une couche de semi-conducteur polycristallin dopé p ;
- recuit sous atmosphère oxydante, diffusant et activant les dopants présents dans la couche de semi-conducteur polycristallin, et formant au moins une deuxième couche d'oxyde de semi-conducteur sur la couche de semi-conducteur polycristallin ;
- réalisation, au moins sur la deuxième couche d'oxyde de semi-conducteur, d'une première couche dopante incluant des dopants de type n, diffusant des dopants type n depuis la première couche dopante jusque dans une première partie de la couche de semi-conducteur polycristallin, à travers la deuxième couche d'oxyde de semi-conducteur, la première partie de la couche de semi-conducteur polycristallin étant disposée entre une deuxième partie de la couche de semi-conducteur polycristallin dans laquelle les dopants de type n n'ont pas diffusés et la deuxième couche d'oxyde de semi-conducteur ;
- retrait de la première couche dopante et de la deuxième couche d'oxyde de semi-conducteur;
et comportant ensuite la réalisation d'une deuxième sous-cellule de la cellule photovoltaïque tandem sur la première partie de la couche de semi-conducteur polycristallin.

Dans ce procédé, la jonction tunnel entre les première et deuxième sous-cellules est formée par les première et deuxième parties de la couche de semi-conducteur polycristalline qui sont dopées selon deux types de conductivité différents.

Ce procédé permet de simplifier la réalisation de la jonction tunnel de la cellule tandem car cette jonction tunnel est réalisée dans une unique couche de semi-conducteur polycristallin, sans avoir à juxtaposer deux couches distinctes avec une couche barrière entre elles.

Dans ce procédé, la mise en oeuvre du recuit sous atmosphère oxydante procure, grâce à la deuxième couche d'oxyde de semi-conducteur formée sur la couche de semi-conducteur polycristallin, un effet barrière partiel vis-à-vis des dopants de type n qui seraient, en l'absence de cette couche d'oxyde de semi-conducteur, susceptibles d'être diffusés dans toute la couche de semi-conducteur polycristallin en raison des étapes mises en oeuvre pour former la première couche dopante. Dans ce procédé, la présence de la deuxième couche d'oxyde de semi-conducteur permet d'obtenir une diffusion des dopants de type n dans une partie seulement (la première partie) de l'épaisseur de la couche de semi-conducteur polycristallin, et de préserver le dopage initial dans le reste (la deuxième partie) de l'épaisseur de la couche de semi-conducteur polycristallin.

La deuxième couche d'oxyde de semi-conducteur peut être conservée sur la couche de semi-conducteur polycristallin lors de la réalisation de la première couche dopante.

Pour obtenir l'effet barrière souhaitée, l'épaisseur de la couche d'oxyde de semi-conducteur est par exemple comprise entre 1 nm et 40 nm, et de préférence entre 1 nm et 30 nm.

Le retrait de la première couche dopante et de la deuxième couche d'oxyde de semi-conducteur peut être mis en oeuvre directement après la réalisation de la première couche dopante, sans étape de recuit de diffusion entre la réalisation de la première couche dopante et ce retrait.

La couche de semi-conducteur polycristallin dopé p peut être réalisée par la mise en oeuvre d'un dépôt d'une couche de semi-conducteur polycristallin intrinsèque, puis une implantation ionique, par exemple par immersion plasma, de dopants de type p dans la couche de semi-conducteur polycristallin. En variante, la couche de semi-conducteur polycristallin dopé p peut être réalisée par la mise en oeuvre d'un dépôt d'une couche de semi-conducteur polycristallin dopé in-situ (c'est-à-dire dopé en même temps que le dépôt) par des dopants de type p.

La deuxième sous-cellule peut comporter au moins une couche de matériau de structure pérovskite.

La réalisation de la deuxième sous-cellule peut comporter au moins la mise en oeuvre des étapes suivantes :
- réalisation d'une couche de transport d'électrons sur la première partie de la couche de semi-conducteur polycristallin ;
- réalisation de la couche de matériau de structure pérovskite sur la couche de transport d'électrons ;
- réalisation d'une couche de transport de trous sur la couche de matériau de structure pérovskite.

L'étape mise en oeuvre pour réaliser la première couche dopante peut réaliser également, du côté d'une deuxième face du substrat semi-conducteur, opposée à la première face, une deuxième couche dopante incluant des dopants de type n, et le procédé peut comporter en outre, après la réalisation de la deuxième couche dopante, la mise en oeuvre d'une diffusion localisée des dopants de type n présents dans la deuxième couche dopante jusque dans une ou plusieurs régions du substrat semi-conducteur localisées sous la deuxième couche dopante.

Le procédé peut comporter en outre :
- après le retrait de la première couche dopante et de la deuxième couche d'oxyde de semi-conducteur, un dépôt d'une couche antireflet du côté de la deuxième face du substrat semi-conducteur, et
- après la réalisation de la couche de transport de trous, la réalisation d'une couche d'oxyde transparent conducteur sur la couche de transport de trous, et
- après le dépôt de la couche antireflet et avant la réalisation de la couche de matériau de structure pérovskite, la réalisation d'électrodes de contact arrière sur les régions du substrat semi-conducteur, à travers la couche antireflet, et
- après la réalisation de la couche d'oxyde transparent conducteur, la réalisation d'électrodes de contact avant sur la couche d'oxyde transparent conducteur.

La réalisation des électrodes de contact avant et arrière peut comporter la mise en oeuvre de dépôts par impression d'une pâte de sérigraphie, puis un recuit de la pâte de sérigraphie.

Les dopants de type p peuvent correspondre à des atomes de bore, et les dopants de type n peuvent correspondre à des atomes de phosphore.

De manière avantageuse, la diffusion localisée peut être mise en oeuvre par laser.

Le recuit sous atmosphère oxydante peut être mis en oeuvre à une température comprise entre 900°C et 950°C et pendant une durée comprise entre 20 minutes et 30 minutes, et/ou la réalisation de la première couche dopante peut être mise en oeuvre à une température comprise entre 780°C et 800°C et pendant une durée comprise entre 10 minutes et 20 minutes.

Selon une réalisation avantageuse, la première couche dopante peut comporter du PSG (« Phosphorus Silica Glass » en anglais, ou verre de phosphosilicate, qui correspond à un oxyde de silicium saturé en phosphore en surface).

L'atmosphère oxydante peut correspondre à une atmosphère de dioxygène.

Le substrat semi-conducteur et la couche de semi-conducteur polycristallin peuvent comporter du silicium.

La couche de semi-conducteur polycristallin peut être déposée par PECVD.

Le procédé peut comporter en outre, avant la réalisation de la première couche d'oxyde, une texturation de la deuxième face du substrat semi-conducteur.

De manière avantageuse, la première couche d'oxyde correspond à une première couche d'oxyde de semi-conducteur, par exemple de SiO₂. En variante, cette première couche d'oxyde peut comporter un oxyde d'un matériau qui n'est pas un semi-conducteur, par exemple de l'oxyde d'aluminium.

Dans l'ensemble du document, le terme « sur » est utilisé sans distinction de l'orientation dans l'espace de l'élément auquel se rapporte ce terme. Par exemple, dans la caractéristique « sur au moins une première face d'un élément », cette première face n'est pas nécessairement orientée vers le haut, mais peut correspondre à une face orientée selon n'importe quelle direction. En outre, la disposition d'un premier élément sur un deuxième élément doit être comprise comme pouvant correspondre à la disposition du premier élément directement contre le deuxième élément, sans aucun élément intermédiaire entre les premiers et deuxièmes éléments, ou bien comme pouvant correspondre à la disposition du premier élément sur le deuxième élément avec un ou plusieurs éléments intermédiaires disposés entre les premier et deuxième éléments. En outre, la disposition d'un premier élément sur un deuxième élément n'implique pas nécessairement que le premier élément soit orienté vers le haut et que le deuxième élément soit orienté vers le bas.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :

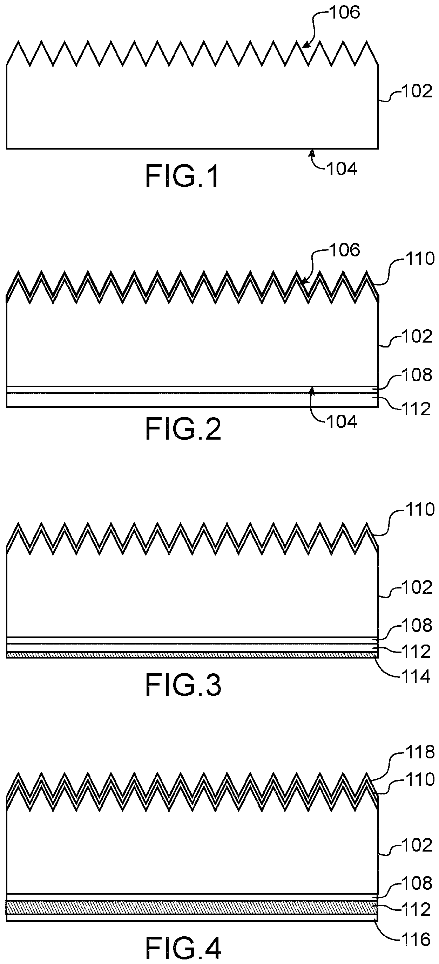

- les figures 1 à 9 représentent les étapes d'un procédé de réalisation d'une cellule photovoltaïque selon un mode de réalisation particulier.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

Un procédé de réalisation d'une cellule photovoltaïque tandem 100 selon un mode de réalisation particulier est décrit ci-dessous en lien avec les figures 1 à 9. Dans ce mode de réalisation particulier, la cellule 100 correspond à une cellule tandem de type PK/Si.

Une première sous-cellule de la cellule 100 est tout d'abord réalisée. Dans le mode de réalisation particulier décrit ici, la première sous-cellule correspond à une cellule inférieure à base de silicium cristallin.

La première sous-cellule est réalisée à partir d'un substrat 102 comportant du semi-conducteur. Ce semi-conducteur correspond avantageusement à du silicium polycristallin ou monocristallin. Le semi-conducteur du substrat 102 est dopé n ou p. Le substrat 102 comporte une première face 104 et une deuxième face 106 opposées l'une de l'autre. Dans l'exemple de réalisation décrit ici, la deuxième face 106 du substrat 102 est destinée à se trouver du côté de la face arrière de la cellule 100 et la première face 104 du substrat 102 est destinée à se trouver du côté de la deuxième sous-cellule de la cellule 100 qui, dans ce premier mode de réalisation, correspond à une cellule supérieure à base de matériau pérovskite.

Une étape de texturation de la deuxième face 106 du substrat 102 est mise en oeuvre. Cette étape de texturation correspond par exemple à une attaque chimique ou toute autre technique adaptée pour réaliser des texturations d'un substrat semi-conducteur adaptées à la réalisation d'une cellule photovoltaïque. Dans l'exemple de réalisation décrit ici, les deux faces 104, 106 du substrat 102 subissent cette étape de texturation, mais un polissage de la première face 104 est ensuite mis en oeuvre afin de ne conserver les texturations qu'au niveau de la deuxième face 106 (voir figure 1). En variante, il est possible de ne pas mettre en oeuvre cette étape de texturation.

Une première couche d'oxyde 108 est ensuite réalisée sur au moins la première face 104 du substrat 102. La première couche d'oxyde 108 correspond avantageusement à une couche d'oxyde de semi-conducteur, ici à une couche de SiO₂ du fait que le substrat 102 comporte du silicium. Cette couche 108 est par exemple réalisée en mettant en oeuvre une oxydation thermique. L'épaisseur de la couche 108 est par exemple égale à 1,5 nm, ou par exemple comprise entre 1 nm et 2 nm. L'épaisseur de la couche 108 est telle que cette couche forme, à l'issue de la réalisation de la cellule 100, une couche tunnel permettant le passage de charges électrique par effet tunnel.

En variante, la première couche d'oxyde 108 peut comporter un oxyde d'un matériau qui n'est pas un semi-conducteur, par exemple de l'oxyde d'aluminium.

Dans l'exemple de réalisation décrit ici, du fait que la couche 108 est formée par oxydation thermique, une fine couche d'oxyde 110 similaire à la couche 108 est également formée sur la deuxième face 106 du substrat 102.

De manière alternative, la première couche d'oxyde 108 peut être réalisée par voie chimique et/ou via une exposition à un rayonnement ultraviolet en présence d'un agent oxydant tel que de l'ozone. Toutefois, l'oxydation thermique est préférée pour la réalisation de la couche 108 en raison de la meilleure conformité conférée dans ce cas à cette couche.

Une couche 112 de semi-conducteur polycristallin (du silicium polycristallin dans l'exemple de réalisation décrit ici) est ensuite déposée sur la couche 108 (voir figure 2). Afin que ce dépôt soit localisé du côté de la couche 108 et non sur la couche 110, la couche 112 peut être déposée par PECVD. Le semi-conducteur polycristallin de couche 112 est ici intrinsèque (non dopé intentionnellement). La couche 112 est ici réalisée telle qu'elle soit suffisamment fine pour éviter une trop forte absorption de la lumière par cette couche 112. Dans l'exemple de réalisation décrit ici, la couche 112 a par exemple une épaisseur comprise entre 30 nm et 150 nm.

Une implantation ionique, avantageusement par immersion plasma (PIII), de dopants de type p dans la couche 112 est ensuite mise en oeuvre. Dans le premier mode de réalisation décrit ici, les dopants de type p correspondent à des atomes de bore. En outre, les dopants sont implantés à travers toute la surface arrière de la couche 112, c'est-à-dire la surface opposée à celle en contact avec la couche 108. La partie dopée obtenue de la couche 112 est désignée, sur la figure 3, par la référence 114. La dose implantée peut être comprise entre 5.10¹⁵ at/cm² et 3.10¹⁶ at/cm², et la tension d'accélération appliquée pour cette implantation peut être comprise entre 2 keV et 8 keV. A titre d'exemple, cette implantation est mise en oeuvre avec une dose égale 1,5.10¹⁶ at/cm² et une tension d'accélération égale à 4 keV.

En variante, cette implantation ionique peut être mise en oeuvre par faisceau d'ions.

La structure réalisée est ensuite soumise à un recuit sous atmosphère oxydante (voir figure 4). Ce recuit va permettre de diffuser dans la couche 112 les dopants précédemment implantés dans la partie 114 de cette couche 112, activer ces dopants, et également former au moins une deuxième couche d'oxyde de semi-conducteur 116 sur la couche 112. Dans l'exemple de réalisation décrit ici, du fait que la couche 112 comporte du silicium, la couche 116 comporte du SiO₂. L'épaisseur de la couche 116 est par exemple comprise entre 1 nm et 30 nm. En outre, dans l'exemple de réalisation décrit ici, ce recuit sous atmosphère oxydante forme également une autre couche 118 d'oxyde de semi-conducteur sur la couche 110. Ce recuit est par exemple mis en oeuvre sous atmosphère de dioxygène. La température du recuit est par exemple comprise entre 900°C et 950°C, pendant une durée par exemple comprise entre 20 nm et 30 mn. La durée du recuit peut être ajustée en fonction de la température avec laquelle le recuit est mis en oeuvre : plus la température de mise en oeuvre sera basse, plus sa durée devra être importante pour obtenir une couche 116 ayant des caractéristiques données.

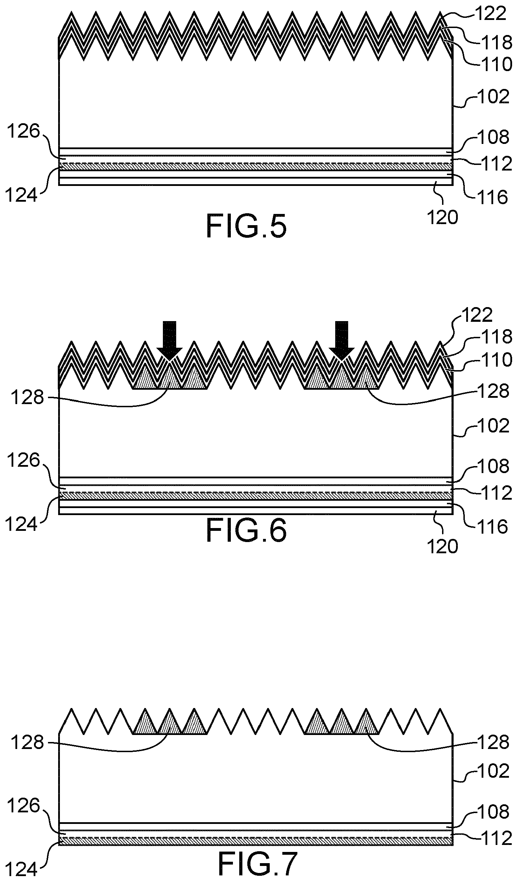

Une première couche dopante 120 incluant des dopants de type n est ensuite réalisée sur la deuxième couche d'oxyde de semi-conducteur 116 (voir figure 5). Les dopants de type n correspondent par exemple à des atomes de phosphore. En outre, dans l'exemple de réalisation décrit ici, la première couche dopante 120 correspond à une couche de PSG obtenue par exemple en mettant en oeuvre une diffusion thermique à basse pression, avec un précurseur contenant du phosphore (par exemple du Trichlorure de phosphoryle, POCl₃) et du dioxygène. Les étapes mises en oeuvre pour réaliser la première couche dopante 120 forment également, du côté de la deuxième face 106 du substrat 102, une deuxième couche dopante 122 similaire à la première couche dopante 120. Dans l'exemple de réalisation décrit ici, en raison de la présence des couches d'oxyde 110 et 118 sur la deuxième face 106 du substrat 102, la couche dopante 120 est réalisée sur la couche d'oxyde 118. Ces étapes sont mises en oeuvre à une température par exemple comprise entre 780°C et 800°C, pendant une durée par exemple comprise entre 10 minutes et 20 minutes. Comme pour le recuit sous atmosphère oxydante, la durée de mise en oeuvre de ces étapes peut être ajustée en fonction de la température utilisée : plus la température de mise en oeuvre sera basse, plus sa durée devra être importante pour obtenir des première et deuxième couches dopantes 120, 122 ayant des caractéristiques données.

Lors de la formation de la première couche dopante 120 (et de la deuxième couche dopante 122 dans l'exemple décrit ici), les dopants de type n se diffusent jusque dans une première partie 124 de la couche 112, à travers la deuxième couche d'oxyde de semi-conducteur 116. Cette première partie 124 de la couche 112 est disposée entre une deuxième partie 126 de la couche 112 dans laquelle les dopants présents dans la première couche dopante 120 n'ont pas diffusés et la deuxième couche d'oxyde de semi-conducteur 116. Au cours de la réalisation de la première couche dopante 120, la présence de la deuxième couche d'oxyde de semi-conducteur 116 permet de limiter la diffusion des dopants depuis la première couche dopante 120 afin que ces dopants ne soient pas diffusés dans toute l'épaisseur de la couche 112 mais uniquement dans la première partie 124 de cette couche 112, ce qui permet à la deuxième partie 126 de la couche 112 de conserver son dopage p.

A l'issue de la réalisation de la première couche dopante 120, les niveaux de dopage dans les première et deuxième parties 124, 126 de la couche 112 sont par exemple compris entre 1.10¹⁹ et 1.10²⁰ at/cm³.

Une étape de diffusion, ou sur-dopage, localisée des dopants de type n présents dans la deuxième couche dopante 122 dans une ou plusieurs régions 128 du substrat 102 est ensuite mise en oeuvre (voir figure 6). La ou les régions 128 sont localisées sous la deuxième couche dopante 122 (et sous les couches 110 et 118 dans l'exemple de réalisation décrit ici). Dans l'exemple de réalisation décrit ici, cette étape de diffusion localisée est mise en oeuvre en exposant certaines zones de la face avant de la structure réalisée à un faisceau laser, ce qui permet de fortement diffuser les atomes depuis les parties de la deuxième couche dopante 122 se trouvant dans ces zones et qui sont exposées à ce faisceau laser, jusque dans les régions 128 du substrat 102.

Comme représenté sur la figure 7, la première couche dopante 120 et la deuxième couche d'oxyde de semi-conducteur 116 présentes sur la couche 112 sont ensuite retirées, par exemple par gravure chimique (par exemple en utilisant une solution de HF). Les couches 110, 118 et 122 présentes sur la deuxième face 106 du substrat 102 sont également retirées par cette gravure.

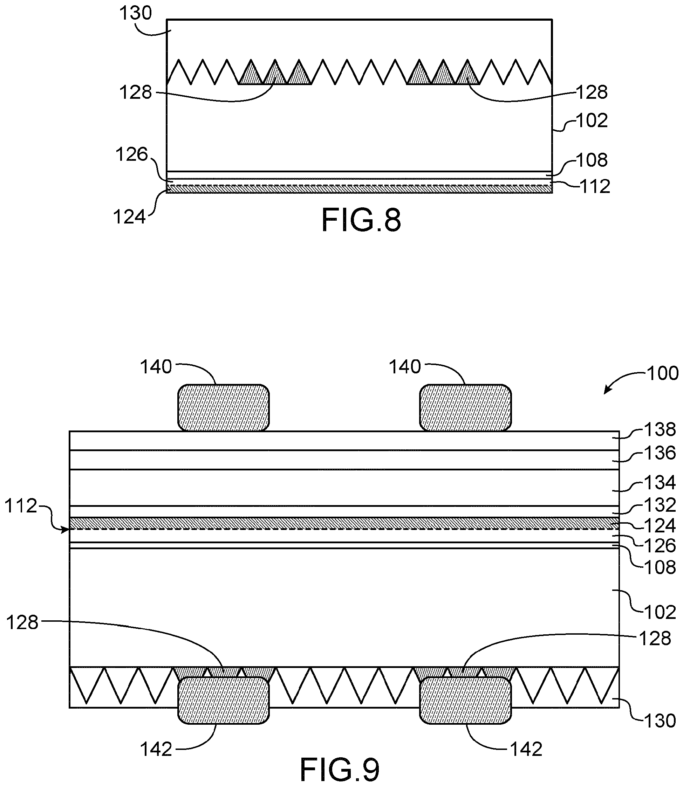

Une couche antireflet 130, comprenant par exemple du SiN:H, est ensuite réalisée sur la structure réalisée, du côté de la deuxième face 106 du substrat 102 (voir figure 8). La couche antireflet 130 est par exemple réalisée par dépôt PECVD.

Des électrodes de contact arrière 142 sont ensuite réalisées à travers la couche antireflet 130 et sont en contact avec les régions 128 du substrat 102. Ces électrodes de contact arrière 142 sont par exemple réalisées par impression d'une pâte de sérigraphie métallique, puis un recuit de la pâte de sérigraphie.

A ce stade du procédé, les étapes mises en oeuvre ont permis la réalisation de la première sous-cellule de la cellule 100, à savoir la cellule inférieure à base de silicium cristallin.

La deuxième sous-cellule de la cellule 100, qui correspond à une cellule supérieure à base de matériau de structure pérovskite dans le mode de réalisation particulier décrit ici, est ensuite réalisée sur la première sous-cellule.

Une couche de transport d'électrons 132, ou ETL pour « Electron Transport Layer » en anglais, est réalisée sur la première partie 124 de la couche 112. La couche de transport d'électrons 132 comporte par exemple au moins l'un des matériaux suivants : TiO₂, ZnO, SnO₂. Cette couche de transport d'électrons 132 est par exemple formée par un dépôt de type ALD (« Atomic Layer Déposition » en anglais, ou dépôt de couche atomique). La couche de transport d'électrons 132 a par exemple une épaisseur comprise entre 5 nm et 30 nm.

Une couche de matériau de structure pérovskite 134 est ensuite réalisée sur la couche de transport d'électrons 132. La couche 134 comporte par exemple du MAPbI₃. La couche 134 est par exemple formée par centrifugation ou par enduction à filière plate. La couche 134 a par exemple une épaisseur comprise entre 500 nm et 1 µm.

Une couche de transport de trous 136, ou HTL pour « Hole Transport Layer » en anglais, est réalisée sur la couche de matériau de structure pérovskite 134. La couche 136 comporte par exemple du PTAA (poly-phényl-trimetyl-amine). La couche 136 est par exemple formée par centrifugation. La couche 136 a par exemple une épaisseur comprise entre 20 nm et 50 nm.

Une couche d'oxyde transparent conducteur 138, TCO pour « Transparent Conductive Oxide » en anglais, est réalisée sur la couche de transport de trous 136. La couche 138 comporte par exemple de l'ITO. La couche 138 est par exemple formée par dépôt de type PVD. La couche 138 a par exemple une épaisseur comprise entre 100 nm et 130 nm.

Des électrodes de contact avant 140 sont ensuite réalisées sur la couche d'oxyde transparent conducteur 138 de la cellule supérieure. Les électrodes de contact avant 140 sont par exemple réalisées par impression d'une pâte de sérigraphie métallique, puis un recuit de la pâte de sérigraphie.

La cellule 100 achevée est représentée schématiquement sur la figure 9.

Dans l'exemple de réalisation décrit ci-dessus, la couche de semi-conducteur polycristallin 112 est réalisée en réalisant dépôt de semi-conducteur polycristallin intrinsèque, puis en réalisant une implantation ionique dans cette couche. En variante, il est possible la couche de semi-conducteur polycristallin 112 soit réalisée en mettant en oeuvre un dépôt d'une couche de semi-conducteur polycristallin dopé in-situ par des dopants du premier type de conductivité.

Dans l'exemple de réalisation décrit ci-dessus, la réalisation d'une seule cellule photovoltaïque 100 est décrite. Ce procédé peut toutefois être mis en oeuvre pour la réalisation simultanée de plusieurs cellules photovoltaïques.

## Revendications

1. Procédé de réalisation d'au moins une cellule photovoltaïque tandem (100), dans lequel une première sous-cellule de la cellule photovoltaïque tandem (100) est réalisée en mettant en oeuvre les étapes de :
- réalisation d'une première couche d'oxyde (108) sur au moins une première face (104) d'un substrat semi-conducteur (102) ;
- réalisation, sur la première couche d'oxyde (108), d'une couche de semi-conducteur polycristallin (112) dopé p ;
- recuit sous atmosphère oxydante, diffusant et activant les dopants présents dans la couche de semi-conducteur polycristallin (112), et formant au moins une deuxième couche d'oxyde de semi-conducteur (116) sur la couche de semi-conducteur polycristallin (112) ;
- réalisation, au moins sur la deuxième couche d'oxyde de semi-conducteur (116), d'une première couche dopante (120) incluant des dopants de type n, diffusant des dopants de type n depuis la première couche dopante (120) jusque dans une première partie (124) de la couche de semi-conducteur polycristallin (112), à travers la deuxième couche d'oxyde de semi-conducteur (116), la première partie (124) de la couche de semi-conducteur polycristallin (112) étant disposée entre une deuxième partie (126) de la couche de semi-conducteur polycristallin (112) dans laquelle les dopants de type n n'ont pas diffusés et la deuxième couche d'oxyde de semi-conducteur (116) ;
- retrait de la première couche dopante (120) et de la deuxième couche d'oxyde de semi-conducteur (116) ;
et comportant ensuite la réalisation d'une deuxième sous-cellule de la cellule photovoltaïque tandem (110) sur la première partie (124) de la couche de semi-conducteur polycristallin (112).

2. Procédé selon la revendication 1, dans lequel la couche de semi-conducteur polycristallin (112) dopé p est réalisée par la mise en oeuvre :
- d'un dépôt d'une couche de semi-conducteur polycristallin (112) intrinsèque, puis une implantation ionique de dopants de type p dans la couche de semi-conducteur polycristallin (112), ou
- d'un dépôt d'une couche de semi-conducteur polycristallin (112) dopé in-situ par des dopants de type p.

3. Procédé selon l'une des revendications précédentes, dans lequel la deuxième sous-cellule comporte au moins une couche de matériau de structure pérovskite (134).

4. Procédé selon la revendication 3, dans lequel la réalisation de la deuxième sous-cellule comporte au moins la mise en oeuvre des étapes suivantes :
- réalisation d'une couche de transport d'électrons (132) sur la première partie (124) de la couche de semi-conducteur polycristallin (112) ;
- réalisation de la couche de matériau de structure pérovskite (134) sur la couche de transport d'électrons (132) ;
- réalisation d'une couche de transport de trous (136) sur la couche de matériau de structure pérovskite (134).

5. Procédé selon l'une des revendications précédentes, dans lequel l'étape mise en oeuvre pour réaliser la première couche dopante (120) réalise également, du côté d'une deuxième face (106) du substrat semi-conducteur (102), opposée à la première face (104), une deuxième couche dopante (122) incluant des dopants de type n,
et comportant en outre, après la réalisation de la deuxième couche dopante (122), la mise en oeuvre d'une diffusion localisée des dopants de type n présents dans la deuxième couche dopante (122) jusque dans une ou plusieurs régions (128) du substrat semi-conducteur (102) localisées sous la deuxième couche dopante (122).

6. Procédé selon les revendications 4 et 5, comportant en outre :
- après le retrait de la première couche dopante (120) et de la deuxième couche d'oxyde de semi-conducteur (116), un dépôt d'une couche antireflet (130) du côté de la deuxième face (106) du substrat semi-conducteur (102), et
- après la réalisation de la couche de transport de trous (136), la réalisation d'une couche d'oxyde transparent conducteur (138) sur la couche de transport de trous (136), et
- après le dépôt de la couche antireflet (130) et avant la réalisation de la couche de matériau de structure pérovskite (134), la réalisation d'électrodes de contact arrière (142) sur les régions (128) du substrat semi-conducteur (102), à travers la couche antireflet (130), et
- après la réalisation de la couche d'oxyde transparent conducteur (138), la réalisation d'électrodes de contact avant (140) sur la couche d'oxyde transparent conducteur (138).

7. Procédé selon la revendication 6, dans lequel la réalisation des électrodes de contact avant et arrière (140, 142) comporte la mise en oeuvre de dépôts par impression d'une pâte de sérigraphie, puis un recuit de la pâte de sérigraphie.

8. Procédé selon l'une des revendications précédentes, dans lequel les dopants de type p correspondent à des atomes de bore, et dans lequel les dopants de type n correspondent à des atomes de phosphore.

9. Procédé selon l'une des revendications précédentes, dans lequel le recuit sous atmosphère oxydante est mis en oeuvre à une température comprise entre 900°C et 950°C et pendant une durée comprise entre 20 minutes et 30 minutes, et/ou la réalisation de la première couche dopante (120) peut être mise en oeuvre à une température comprise entre 780°C et 800°C et pendant une durée comprise entre 10 minutes et 20 minutes.

10. Procédé selon l'une des revendications précédentes, dans lequel la deuxième couche d'oxyde de semi-conducteur (116) est conservée sur la couche de semi-conducteur polycristallin (112) lors de la réalisation de la première couche dopante (120).

11. Procédé selon l'une des revendications précédentes, dans lequel la première couche dopante (120) comporte du PSG, et/ou dans lequel l'atmosphère oxydante correspond à une atmosphère de dioxygène.

12. Procédé selon l'une des revendications précédentes, dans lequel le substrat semi-conducteur (102) et la couche de semi-conducteur polycristallin (112) comportent du silicium.

13. Procédé selon l'une des revendications précédentes, dans lequel la couche de semi-conducteur polycristallin (112) est déposée par PECVD.

14. Procédé selon l'une des revendications précédentes, comportant en outre, avant la réalisation de la première couche d'oxyde (108), une texturation de la deuxième face (106) du substrat semi-conducteur (102).

## Patentansprüche

1. Verfahren zum Herstellen mindestens einer Tandem-Photovoltaikzelle (100), wobei eine erste Unterzelle der Tandem-Photovoltaikzelle (100) durch Ausführen der folgenden Schritte hergestellt wird:
- Herstellen einer ersten Oxidschicht (108) auf mindestens einer ersten Fläche (104) eines Halbleitersubstrats (102);
- Herstellen einer p-dotierten polykristallinen Halbleiterschicht (112) auf der ersten Oxidschicht (108);
- Glühen in einer oxidierenden Atmosphäre, um die in der polykristallinen Halbleiterschicht (112) vorhandenen Dotierstoffe zu diffundieren und zu aktivieren und um mindestens eine zweite Halbleiteroxidschicht (116) auf der polykristallinen Halbleiterschicht (112) zu bilden;
- Erzeugen einer ersten Dotierschicht (120), die n-Typ-Dotierstoffe enthält, zumindest auf der zweiten Halbleiteroxidschicht (116), indem die n-Typ-Dotierstoffe aus der ersten Dotierschicht (120) in einen ersten Teil (124) der polykristallinen Halbleiterschicht (112) durch die zweite Halbleiteroxidschicht (116) hindurch diffundiert werden, wobei der erste Teil (124) der polykristallinen Halbleiterschicht (112) zwischen einem zweiten Teil (126) der polykristallinen Halbleiterschicht (112), in den die n-Typ-Dotierstoffe nicht diffundiert sind, und der zweiten Halbleiteroxidschicht (116) angeordnet ist;
- Entfernen der ersten Dotierschicht (120) und der zweiten Halbleiteroxidschicht (116);
und anschließend umfassend das Herstellen einer zweiten Unterzelle der Tandem-Photovoltaikzelle (110) auf dem ersten Teil (124) der polykristallinen Halbleiterschicht (112).

2. Verfahren nach Anspruch 1, wobei die p-dotierte polykristalline Halbleiterschicht (112) durch Ausführen des Folgenden hergestellt wird:
- Abscheiden einer intrinsischen polykristallinen Halbleiterschicht (112), dann lonenimplantation von p-Typ-Dotierstoffen in die polykristalline Halbleiterschicht (112), oder
- Abscheiden einer polykristallinen Halbleiterschicht (112), die in situ mit p-Typ-Dotierstoffen dotiert ist.

3. Verfahren nach einem der vorhergehenden Ansprüche, wobei die zweite Unterzelle mindestens eine Schicht mit Perowskit-Strukturmaterial (134) umfasst.

4. Verfahren nach Anspruch 3, wobei das Herstellen der zweiten Unterzelle mindestens das Ausführen der folgenden Schritte umfasst:
- Erzeugen einer Elektronentransportschicht (132) auf dem ersten Teil (124) der polykristallinen Halbleiterschicht (112);
- Erzeugen der Perowskit-Strukturmaterialschicht (134) auf der Elektronentransportschicht (132);
- Erzeugen einer Lochtransportschicht (136) auf der Schicht aus Perowskit-Strukturmaterial (134).

5. Verfahren nach einem der vorhergehenden Ansprüche, wobei der Schritt, der zum Herstellen der ersten Dotierschicht (120) durchgeführt wird, außerdem auf der Seite einer zweiten Fläche (106) des Halbleitersubstrats (102), die der ersten Seite (104) gegenüberliegt, eine zweite Dotierschicht (122) herstellt, die n-Typ-Dotierstoffe enthält,
und ferner umfassend, nach dem Herstellen der zweiten Dotierschicht (122), das Durchführen einer lokalen Diffusion der in der zweiten Dotierschicht (122) vorhandenen n-Typ-Dotierstoffe in einen oder mehrere Bereiche (128) des Halbleitersubstrats (102), die unter der zweiten Dotierschicht (122) liegen.

6. Verfahren nach den Ansprüchen 4 und 5, ferner umfassend:
- nach dem Entfernen der ersten Dotierschicht (120) und der zweiten Halbleiteroxidschicht (116), Abscheiden einer Antireflexionsschicht (130) auf der Seite der zweiten Fläche (106) des Halbleitersubstrats (102), und
- nach dem Herstellen der Lochtransportschicht (136), Herstellen einer transparenten leitenden Oxidschicht (138) auf der Lochtransportschicht (136), und
- nach dem Abscheiden der Antireflexionsschicht (130) und vor dem Herstellen der Schicht aus Perowskit-Strukturmaterial (134), Herstellen von hinteren Kontaktelektroden (142) auf den Bereichen (128) des Halbleitersubstrats (102) durch die Antireflexionsschicht (130) hindurch, und
- nach dem Herstellen der transparenten leitenden Oxidschicht (138), Herstellen von vorderen Kontaktelektroden (140) auf der transparenten leitenden Oxidschicht (138).

7. Verfahren nach Anspruch 6, wobei das Herstellen der vorderen und hinteren Kontaktelektroden (140, 142) das Durchführen von Abscheidungen durch Aufdrucken einer Siebdruckpaste und anschließendem Glühen der Siebdruckpaste umfasst.

8. Verfahren nach einem der vorhergehenden Ansprüche, wobei die p-Typ-Dotierstoffe Boratomen entsprechen und wobei die n-Typ-Dotierstoffe Phosphoratomen entsprechen.

9. Verfahren nach einem der vorhergehenden Ansprüche, wobei das Glühen in einer oxidierenden Atmosphäre bei einer Temperatur zwischen 900 °C und 950 °C und in einem Zeitraum zwischen 20 Minuten und 30 Minuten durchgeführt wird und/oder das Herstellen der ersten Dotierschicht (120) bei einer Temperatur zwischen 780 °C und 800 °C und in einem Zeitraum zwischen 10 Minuten und 20 Minuten durchgeführt werden kann.

10. Verfahren nach einem der vorhergehenden Ansprüche, wobei während des Herstellens der ersten Dotierschicht (120) die zweite Halbleiteroxidschicht (116) auf der polykristallinen Halbleiterschicht (112) beibehalten wird.

11. Verfahren nach einem der vorhergehenden Ansprüche, wobei die erste Dotierschicht (120) PSG umfasst und/oder wobei die oxidierende Atmosphäre einer Sauerstoffatmosphäre entspricht.

12. Verfahren nach einem der vorhergehenden Ansprüche, wobei das Halbleitersubstrat (102) und die polykristalline Halbleiterschicht (112) Silizium umfassen.

13. Verfahren nach einem der vorhergehenden Ansprüche, wobei die polykristalline Halbleiterschicht (112) durch PECVD abgeschieden wird.

14. Verfahren nach einem der vorhergehenden Ansprüche, ferner umfassend ein Texturieren der zweiten Fläche (106) des Halbleitersubstrats (102) vor dem Herstellen der ersten Oxidschicht (108).

## Claims

1. A method for making at least one tandem photovoltaic cell (100), wherein a first sub-cell of the tandem photovoltaic cell (100) is made by applying the following steps:
- making a first oxide layer (108) on at least a first surface (104) of a semiconductor substrate (102);
- making a p-doped polycrystalline semiconductor layer (112) on the first oxide layer (108);
- annealing in an oxidizing atmosphere, diffusing and activating the dopants present in the polycrystalline semiconductor layer (112), and forming at least a second semiconductor oxide layer (116) on the polycrystalline semiconductor layer (112);
- making, at least on the second semiconductor oxide layer (116), a first doping layer (120) including n-type dopants, diffusing n-type dopants from the first doping layer (120) into a first portion (124) of the polycrystalline semiconductor layer (112), through the second semiconductor oxide layer (116), the first portion (124) of the polycrystalline semiconductor layer (112) being arranged between a second portion (126) of the polycrystalline semiconductor layer (112) into which the n-type dopants have not diffused and the second semiconductor oxide layer (116);
- removing the first dopant layer (120) and the second semiconductor oxide layer (116);
and then comprising making a second sub-cell of the tandem photovoltaic cell (110) on the first portion (124) of the polycrystalline semiconductor layer (112).

2. The method according to claim 1, wherein the p-doped polycrystalline semiconductor layer (112) is made by applying the following steps:
- deposition of an intrinsic polycrystalline semiconductor layer (112), followed by an ion implantation of p-type dopants into the polycrystalline semiconductor layer (112); or
- deposition of an polycrystalline semiconductor layer (112) doped *in-situ* by p-type dopants.

3. The method according to claim 1, wherein the second sub-cell comprises at least one layer of perovskite structure material (134).

4. The method according to any of the preceding claims, wherein making the second sub-cell comprises at least applying the following steps:
- making an electron transport layer (132) on the first portion (124) of the polycrystalline semiconductor layer (112);
- making the perovskite structure material layer (134) on the electron transport layer (132);
- making a hole transport layer (136) on the perovskite structure material layer (134).

5. The method according to any of the preceding claims, wherein the step applied to make the first dopant layer (120) also makes, on the side of the second surface (106) of the semiconductor substrate (102), opposite the first surface (104) a second dopant layer (122) including type-n dopants,
and further comprising, after making the second doping layer (122), applying a localised diffusion of the n-type dopants present in the second doping layer (122) into one or more regions (128) of the semiconductor substrate (102) located beneath the second doping layer (122).

6. The method according to claims 4 and 5, further comprising:
- after removing the first doping layer (120) and the second semiconductor oxide layer (116), deposition of an anti-reflection layer (130) on the second surface (106) of the semiconductor substrate (102), and
- after the hole transport layer (136) has been made, making a conductive transparent oxide layer (138) on the hole transport layer (136), and
- after the deposition of the anti-reflection layer (130) and before making the perovskite structure material layer (134), making back contact electrodes (142) on the regions (128) of the semiconductor substrate (102) through the anti-reflection layer (130), and
- after the transparent conductive oxide layer (138) is made, making front contact electrodes (140) on the transparent conductive oxide layer (138).

7. The method according to claim 6, wherein making the front and back contact electrodes (140, 142) comprises printing depositions using a screen printing paste and then annealing the screen printing paste.

8. The method according to any of the previous claims, wherein the p-type dopants are boron atoms, and wherein the n-type dopants are phosphorus atoms.

9. The method according to any of the previous claims, wherein the annealing in an oxidising atmosphere is applied at a temperature ranging between 900°C and 950°C and for a period ranging between 20 minutes and 30 minutes, and/or the first doping layer (120) may be made at a temperature ranging between 780°C and 800°C and for a period ranging between 10 minutes and 20 minutes.

10. The method according to any of the previous claims, wherein the second semiconductor oxide layer (116) is present on the polycrystalline semiconductor layer (112) during the making of the first doping layer (120).

11. The method according to any of the previous claims, wherein the first doping layer (120) comprises PSG, and/or wherein the oxidising atmosphere is a dioxygen atmosphere.

12. The method according to any of the previous claims, wherein the semiconductor substrate (102) and the polycrystalline semiconductor layer (112) comprise silicon.

13. The method according to any of the previous claims, wherein the deposition of the polycrystalline semiconductor layer (112) is performed by PECVD.

14. The method according to any of the previous claims, further comprising texturing the second surface (106) of the semiconductor substrate (102) before making the first oxide layer (108).
